# EUROPEAN PATENT APPLICATION

(11) **EP 4 773 449 A1**
(43) Date of publication of application: **08.07.2026**
(21) Application number: 25225369.5
(22) Date of filing: 19.12.2025
(51) Int. Cl.: H01S 5/12, H01S 5/10, H01S 5/14, H01S 5/125, H01S 5/024, H01S 5/0683, H01S 5/34, H01S 5/06

(54) **COMPACT EXTERNAL CAVITY LASER**

(30) Priority: 31.12.2024 US 202419006637
(71) Applicant: Cisco Technology, Inc., San Jose, CA 95134-1706 (US)
(72) Inventor: Huang, Xue, San Jose, 95134-1706 (US); Chen, Long, San Jose, 95134-1706 (US)
(74) Representative: Noble, Nicholas

(57) **Abstract**

In part, in one embodiment the disclosure relates to a laser that includes a laser cavity; an optical gain chip that includes a gain material, the gain material having a gain region, the optical gain chip includes a first waveguide, the first waveguide defines a first section of the laser cavity; an external laser cavity includes a second waveguide, the second waveguide is optically coupled to the first waveguide, the second waveguide defines a second section of the laser cavity; and a DBR ring optically coupled to the second waveguide, the DBR ring includes a loop waveguide optically coupled to the second waveguide and one or more DBR disposed along one or more sections of the loop waveguide, the laser cavity includes the first section of the laser cavity and the external laser cavity; and a PIC that includes the second waveguide and the DBR ring.

## Description

### FIELD

This disclosure relates generally to the fields of photonic integrated circuits and coherent optical telecommunication systems.

### BACKGROUND

Contemporary optical communications and other photonic systems make extensive use of photonic integrated circuits that are advantageously mass-produced in various configurations for various purposes.

### BRIEF DESCRIPTION OF THE FIGURES

Unless specified otherwise, the accompanying drawings illustrate aspects of the innovations described herein. Referring to the drawings, wherein like numerals refer to like parts throughout the several views and this specification, several embodiments of presently disclosed principles are illustrated by way of example, and not by way of limitation. The drawings are not intended to be to scale. A more complete understanding of the disclosure may be realized by reference to the accompanying drawings in which:
Figure 1A is a diagram of an external cavity laser including a distributed Bragg reflector ring according to an exemplary embodiment of the disclosure.
Figure 1B is an alternative diagram of an external cavity laser according to an exemplary embodiment of the disclosure.
Figure 2A is a plot of an amount of optical transmission or reflection of a distributed Bragg reflector according to an exemplary embodiment of the disclosure.
Figure 2B is a plot of an amount of optical transmission or reflection of a loop waveguide or ring resonator according to an exemplary embodiment of the disclosure.
Figure 2C is a plot comparing certain ring and Bragg reflector combinations according to an exemplary embodiment of the disclosure.

### OVERVIEW

In part, in one aspect, the disclosure relates to a laser. The laser includes a laser cavity; an optical gain chip that includes a gain material, the gain material having a gain region, the optical gain chip includes a first waveguide, wherein the first waveguide defines a first section of the laser cavity; an external laser cavity includes a second waveguide, wherein the second waveguide is optically coupled to the first waveguide, the second waveguide defines a second section of the laser cavity; and a distributed Bragg reflector (DBR) ring optically coupled to the second waveguide, the DBR ring includes a loop waveguide optically coupled to the second waveguide and one or more DBR disposed along one or more sections of the loop waveguide, wherein the laser cavity includes the first section of the laser cavity and the external laser cavity; and a photonic integrated circuit (PIC), the PIC includes the second waveguide and the DBR ring.

In part, in one aspect, the disclosure relates to a method. The method includes transmitting a laser beam back and forth between a gain chip and an external laser cavity, wherein the gain chip provides optical gain, wherein the laser beam wavelength is tunable within a range; selecting, using a DBR ring, a center wavelength from the range of wavelengths; transmitting the laser beam having a center wavelength from the DBR to a first waveguide; selecting, using one or more parameters of the DBR ring, between a transmission direction and a reflection direction, wherein the transmission direction is orientable such that it can orient towards the laser output; and transmitting the laser beam having a center wavelength from the laser output. In some embodiments, the transmission direction is oriented towards an electro-optical device or an optical device other than the laser output.

### EXAMPLE EMBODIMENTS

In part, in one aspect, the disclosure relates to a compact, integrated distributed Bragg reflector (DBR) ring laser. In one aspect, coherent telecommunications systems using coherent transceivers require widely tunable lasers with a wavelength tuning range of greater than 45 nm, a high optical power of greater than 16 dBm, a low linewidth of less than 100 kHz, and highly accurate tunability of optical wavelength to within ±1.5 GHz because both amplitude and phase encode information. In another aspect, widely tunable lasers with such constraints have been realized with external cavity lasers consisting of free-space wavelength-selective elements, photonic integrated circuits (PICs), or integrated sampled grating distributed Bragg reflector (SGDBR) components, but at significantly higher cost and higher power consumption than lasers used in direct detection communication systems in which a signal is encoded only with modulation of a power of a laser.

In one aspect of the disclosure, coherent communications systems benefit from having compact lasers that provide highly accurate wavelength tuning, low linewidth, and low power consumption to be feasible. In one aspect, distributed feedback lasers (DFBs) may serve as source lasers in coherent telecommunications systems with narrow wavelength tuning range constraints but benefit from configuration and modifications to avoid certain problems. For example, to provide a tunable target wavelength output under a wide ambient temperature range, a e.g. 15 ~ 80 °C, a DFB will require a thermoelectric cooler (TEC) to maintain a constant temperature for laser emission at the target wavelength. In various embodiments, the laser or the external cavity thereof operates in an uncooled state such as in the absence of a TEC or other cooler. Furthermore, if instead a heater is used to maintain a constant, high temperature, e.g. 80 °C, independent of ambient temperature, a DFB will consume significantly higher power, e.g. 1.5 W, especially at lower ambient temperatures, e.g. 15 °C. Operating a DFB laser at such a high temperature may also degrade a laser lifetime. Finally, at an end-of-life (EOL) of a DFB laser, an accuracy of ±1.5 GHz may not be achievable.

In part, to meet design constraints of laser sources for coherent telecommunications systems, a compact, low-power-consumption laser based on a DBR ring is disclosed herein. In one aspect, the compact DBR ring laser is an external cavity laser comprising a photonic integrated circuit (PIC) that is optically coupled to an optical gain chip. In one aspect, the PIC includes a traveling-wave resonator that is optically coupled to a waveguide that forms a part of the external cavity. The traveling-wave resonator or ring resonator may generally be referred to as a loop in some embodiments and can be in the shape of a circle, an ellipse, or a racetrack, or other closed loops, etc. Hereafter it is referred to as a ring resonator for simplicity. The ring resonator has a distributed Bragg reflector (DBR) disposed on the ring resonator. The DBR is operable to induce a coupling between light propagating in opposite directions inside the ring resonator based on a choice of various design parameters of the DBR or various optical coupling coefficients. Only optical frequencies that resonate in the ring resonator will be strongly coupled to the DBR ring, and of those optical frequencies, only an optical frequency matching a Bragg frequency of the DBR will be reflected back to an incoming waveguide. The DBR ring is a wavelength-selective mirror that determines an optical frequency of the external cavity laser. In another aspect, the DBR ring may be heated by a local heater or thermo-optical phase shifter (TOPS) to compensate for an optical phase shift due to a temperature change or to tune the optical frequency of the laser.

In various aspects, the compact DBR ring laser may be used in coherent optical telecommunications applications with a narrow wavelength tuning range of less than or approximately equal to 10 nm. In one aspect, the DBR ring laser can operate in an uncooled state and in a cooled state. As operation in a cooled state, i.e. with a thermoelectric cooler (TEC), may consume additional power, the DBR ring laser can operate without a thermoelectric cooler (TEC) and without a gain chip heater.

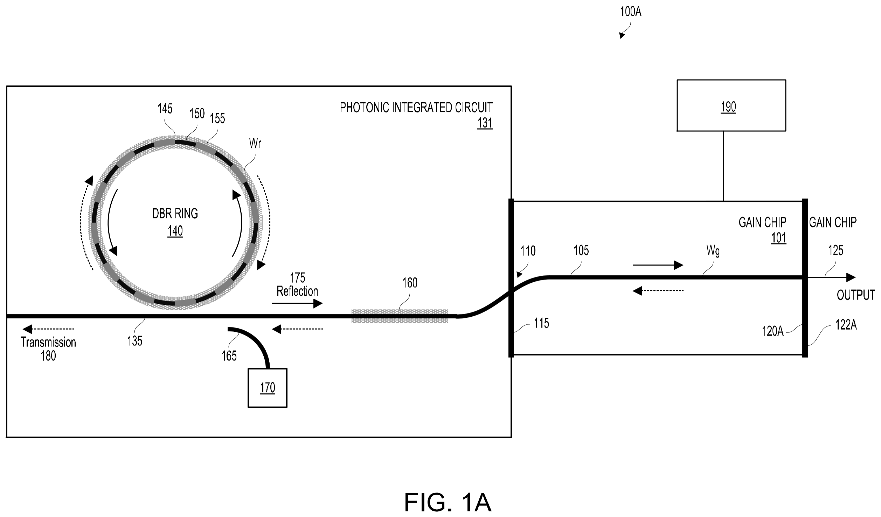

Refer now to the exemplary embodiment of Figure 1A. Figure 1A is a diagram of laser 100A including a distributed Bragg reflector ring. The laser 100A includes an optical gain chip 101 that is optically coupled to a photonic integrated circuit (PIC) 131. In most embodiments, the optical gain chip includes a first waveguide 105 that spans a first facet 115 of the optical gain chip and a second facet 120A of the optical gain chip. The gain chip includes or defines a gain region that may include one or more structures. The gain chip also includes a gain material. In some embodiments, the first facet 115 is coated with an anti-reflective (AR) coating and the second facet 120A is coated with a partially reflective (PR) coating 122A, permitting a laser output 125 from the second facet. In some embodiments, the AR coating may provide a reflectivity of less than about 0.1 % and the PR coating may provide a reflectivity of around 1 % to around 20 %. In most embodiments, the PIC includes a second waveguide 135. In most embodiments, the gain chip is optically coupled to the PIC at an optical interface or optical coupling 110. The first waveguide 105 is optically coupled to the second waveguide 135 at the optical interface or optical coupling 110. In some embodiments, the optical paths that are connected to the optical gain chip define an external optical cavity or portions thereof. The various waveguides disclosed herein may be formed using semiconductor layers, optical fiber segments, or other optically transmissive materials suitable for transmitting laser light. In some embodiments, the gain chip emits light having a gain chip wavelength range. The gain chip wavelength range may span spans a width of about 20 nm to about 200 nm. In some embodiments, the DBR ring circulates light having a wavelength tuning range that ranges from ± about 8 nm. The optical gain chip may include one or more quantum well or quantum dot structures.

In most embodiments, the optical gain chip is operable to provide an optical gain to light under an electrical bias. In various embodiments, the optical gain chip is fabricated from group III-V semiconductor materials. In some embodiments, a gain region of the optical gain chip may include quantum well (QW) or quantum dot (QD) structures.

In most embodiments, the PIC further includes a distributed Bragg reflector (DBR) ring 140. The DBR ring includes a loop waveguide or ring resonator 150 that is optically coupled to the second waveguide 135. The DBR ring 140 further includes a distributed Bragg reflector / DBR 155 overlaid on the ring resonator. The DBR includes a grating. In some embodiments, the loop waveguide is a circular waveguide, an elliptical waveguide, or another waveguide that includes a closed loop. The grating of the DBR may be applied on all, substantially all, or some portion of the loop waveguide of the DBR ring 140. For example, the DBR ring may have a grating along about 99% or the loop waveguide or about 50% of the loop waveguide or some other percentage in some embodiments. The DBR ring may have a grating along a circumference or along one or more arcs of the loop waveguide. As described earlier, the ring resonator may be any closed loop, such as an ellipse, a racetrack, etc. The DBR introduces a periodic or quasi-periodic perturbation to an effective mode index of the ring resonator. A DBR may have various implementation in various embodiments. In at least one embodiment, the DBR may be implemented by changing a width of the ring resonator directly. Such width change may be a periodic step change or a continuous sinusoidal profile. An amplitude of a width change may be in a range of about 1 nm to about 0.5 µm depending on a waveguide material and geometry. In other embodiments, the DBR may be implemented by introducing perturbations to an evanescent field of the ring resonator from a side or from above or below the ring resonator. For example, in some embodiments, a DBR may comprise small pillars placed periodically on an inside or outside perimeter of the ring resonator. The small pillars may be fabricated from a same material as the ring resonator. In other embodiments, scatterers may be patterned in layers above or below the ring resonator.

In various embodiments, the ring DBR 140 is a continuous and closed loop. The ring DBR defines an optical path or loop that is part of the cavity of a laser such as a laser fabricated on or in a PIC. In some embodiments, the optical paths that are connected to the optical gain chip including the DBR ring and one or more waveguides on the PIC define the external cavity of the laser. In other embodiments, external cavity of the laser includes the DBR ring alone or with other waveguides. The diameter of the DBR ring 140 may range from about 2.0 µm to about 2.0 mm. The optical path length or circumference of the DBR ring 140 may range from about 6.0 µm to about 6.0 mm. In various embodiments, the length of PIC 131 may range from about 0.2 mm to about 10.0 mm. In various embodiments, the width of PIC 131 may range from about 0.2mm to about 10.0 mm.

In some embodiments, a first local heater 145 such as a thermo-optical phase shifter (TOPS) heats the DBR ring to tune a laser wavelength or to compensate an optical phase shift that may be induced by a change in an ambient temperature. Similarly, in various embodiments, an optional, second local heater 160 such as a second TOPS heats a region of the second waveguide 135 to compensate for an optical phase shift that may be induced by a change in an ambient temperature. In some embodiments, the first TOPS (first heater 145) or the second TOPS (second heater 160) may be thermally isolated or partially isolated from the PIC via a semiconductor etch fabrication process.

In most embodiments, the DBR ring acts as a wavelength-selective filter to select a desired lasing wavelength. By a choice of a DBR grating coupling constant and a coupling efficiency between the DBR ring and the second waveguide 135, an amount of reflection light 175 in a direction of the gain chip may be tuned, or equivalently an amount of transmission light 180 in a direction away from the gain chip may be tuned. In some embodiments, the DBR ring outputs coherent light having a central wavelength with a wavelength spread of ± about 8 nm. DBR grating coupling constant may range from about 0.1 to about 100, and the ring-to-waveguide coupling efficiency may range from about 5.0% to about 95%. The DBR ring is a closed loop in various embodiments. In some embodiments, the transmission light 180 percentage is about 0 % and the reflection light 175 percentage is about 100%. The foregoing allocation of reflection and transmission percentages may be used when the objective is for approximately all of the laser light to be directed out of the laser output without any of the transmission light being used for other optical functions or operations on the PIC or other components connected thereto.

In some embodiments, the DBR ring is offset from waveguide 135 by a separation distance. The separation distance may range from about 10 nm to about 1 µm in some embodiments. In embodiments where the DBR ring is designed such that all optical power is reflected toward the optical gain chip, a laser output 125 is defined at or by the second facet 120A of the optical gain chip or in optical communication with the second facet 120A. In various embodiments, the wavelength of light in the DBR Wᵣ may range from about 100 nm to about 100 µm. In various embodiments, the wavelength of light in the gain chip Wg may range from about 100 nm to about 100 µm. Wᵣ and Wg are generally the same wavelength.

In some embodiments, the length of the laser cavity (including the external laser cavity) ranges from about 100 µm to about 10 cm. In various embodiments, the laser cavity is defined by the gain chip section and external cavity including the DBR. In most embodiments, the lasing wavelength is the same for the internal cavity and the external cavity including the DBR. In some embodiments, the first waveguide has a first end that coincides with the first facet and a second end that coincides with the second facet. In various embodiments, a given surface of a facet may be coated with anti-reflective coating. In some embodiments, the laser output is disposed in the PIC or wherein the laser output receives laser light from the second end.

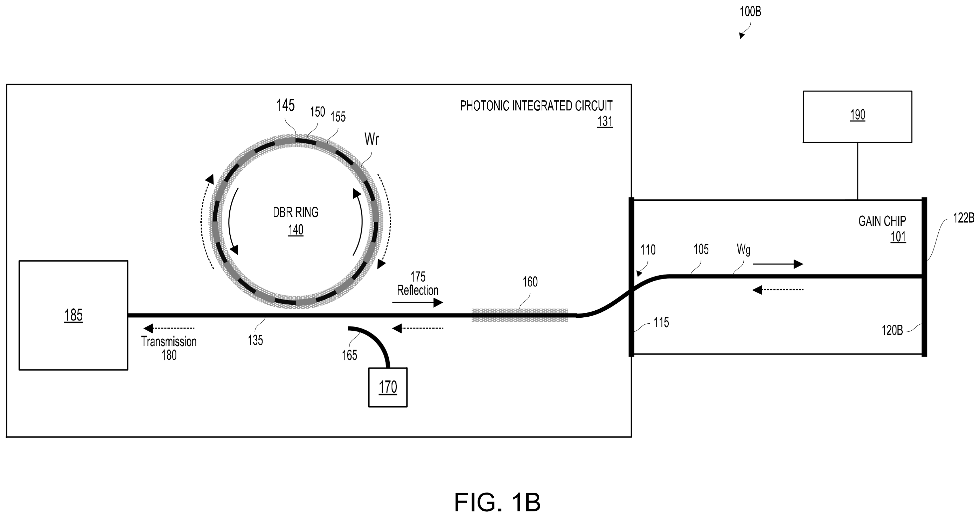

Refer now to the exemplary embodiment of Figure 1B. Figure 1B is a diagram of a laser 100B that includes a distributed Bragg reflector ring. In other embodiments, such as the embodiment shown in Figure 1B, the DBR ring may be designed as part of the external cavity for the laser such that laser light is partially transmitted and partially reflected based on a specified percentage and along two or more optical paths. For example, a 95 % transmission and a 5 % reflection of optical power may be specified based on the arrangement of design parameters including the DBR coupling constant and ring-to-waveguide coupling efficiency of the DBR ring. The light that is transmitted or transmission light 180 from the DBR ring and the light that is reflected or the reflection light 175 from the DBR ring may be directed along different optical paths as shown in Figure 1B. In some embodiments, the transmission percentage for the DBR ring ranges from greater than about 0 %to less than about 100%. In some embodiments, the reflection percentage for the DBR ring ranges from greater than about 0 %to less than about 100%.

In various embodiments, the transmission light 180 and reflection light 175 may by reversed and different percentages of transmission and reflection may be selected based on the configuration and/or properties of the DBR ring. In some embodiments, the percentage of transmission light 180 is a directed away from the optical gain chip (in a transmission direction) along a waveguide or optical bus and into additional components 185 on the PIC. In various embodiments, one or more of waveguides depicted and described herein may define an optical bus. In some embodiments, the optical bus refers to waveguides in the PIC other than the DBR ring. Further, in some embodiments, the percentage of reflection light 175 is a directed towards the optical gain chip (in a reflection direction) along a waveguide or optical bus and towards a laser output 125. In such embodiments, the second facet 120B of the optical gain chip may be coated with a highly reflective (HR) coating 122B. The reflection direction and transmission direction may be reversed or swapped in some embodiments.

In various embodiments, the additional components 185 may include optical output ports, optical modulators, waveguides, local oscillators, optical sensors, LiDAR, a system-on-chip (SoC), a transmitter, a receiver, or other integrated photonic components and combinations thereof. Laser 100A and laser 100B may also include a control system 190 that may include a power supply and other electronical components and circuits suitable for power and/or biasing the optical gain chip 101. In various embodiments, the second facet 120B and 120A may be covered with different coatings in various embodiments including reflective, partially reflective, or anti-reflective coatings. The lasers disclosed herein may include a laser output port that disposed or formed in the PIC or disposed or arranged relative to the gain chip in various embodiments. Laser 100A and laser 100B are external cavity lasers in various embodiments.

In various embodiments, while a DBR ring structure and the second waveguide 135 may be physically fixed after fabrication, a coupling coefficient between the DBR ring and the second waveguide may still be tunable, and so an amount of reflection or transmission of the DBR ring may be tunable even after fabrication. For example, in some embodiments, with additional micro-electro-mechanical systems (MEMS) components, a proximity of the second waveguide 135 to the DBR ring may be adjusted. In such embodiments, the second waveguide may be pushed laterally away from or pulled laterally toward the DBR ring if the second waveguide and the DBR ring are in a same fabrication layer, or the second waveguide and the DBR ring may be pushed vertically away from or pulled vertically toward the DBR ring if the second waveguide and the DBR ring are in different fabrication layers.

In other embodiments, the PIC may further include additional electro-optical components 170. The components may be electrical components, optical components, or components that combine electrical and optical elements or functionalities. The components 170 may include one or more power monitors, photodetectors, or wavelength lockers. In some embodiments the additional optical elements may be optically coupled to the cavity via a waveguide 165. In some embodiments, one or more of the components 170 may be in electrical or optical communication (or both) with control system 190.

In various embodiments, such as the example embodiments of Figures 1A and 1B, the optical gain chip and the PIC are optically coupled using edge coupling such as die edge coupling. In other embodiments, the optical gain chip may be optically coupled to the PIC with an evanescent coupling or with a surface grating coupler coupling. In some embodiments, the optical gain chip may be integrated with the PIC die by various methods such as III-V to PIC die bonding, wafer bonding, III-V epitaxial growth on Si, or other bonding or integration methods.

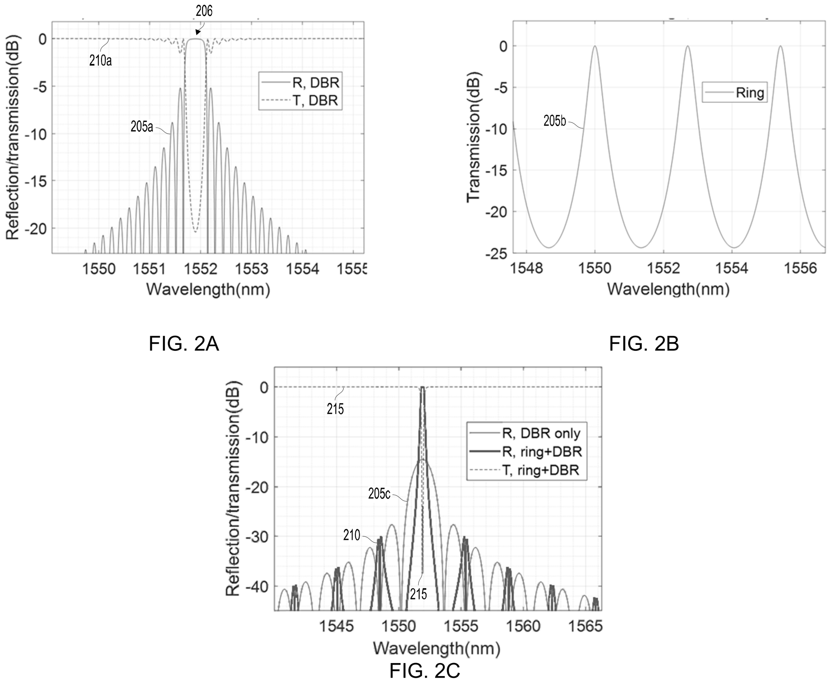

Refer now to the exemplary embodiment of Figure 2A which shows a reflection spectrum 205a and a transmission spectrum 210a of a conventional, linear DBR of length about 2.5 mm. A conventional DBR can provide a single peak 206 in a reflection spectrum 205a at a particular wavelength, but in most embodiments the peak in reflection from a conventional DBR usually has a broad bandwidth. For example, in Figure 2A, a full width at half maximum bandwidth of the single peak 206 in the amount of reflection from the conventional DBR is 56 GHz. In many embodiments, a DBR with such a broad peak may allow for undesirable mode competition in long cavity lasers which have a small free spectral range, e.g. less than 50 GHz. Furthermore, in most embodiments, a very long DBR (2.5 mm in Figure 2A) may be used to achieve a high reflectivity of close to 100% and, in most embodiments, a TOPS used to adjust a resonant frequency of a long DBR would use a large amount of power. The TOPS may be in thermal communication with various elements disclosed herein such as a cavity or a DBR ring.

Refer now to Figure 2B which shows a transmission spectrum 205b of a ring resonator of radius about 35 µm that is optically coupled to a waveguide. In many embodiments, because a ring resonator usually has a high Q-factor, its transmission peaks are narrow, e.g. a full width at half maximum bandwidth of 36 GHz, and so a ring resonator is better able to suppress side cavity modes. However, in various embodiments, a transmission spectrum of a ring resonator is a wavelength comb and does not select a single wavelength. To select a single wavelength, two ring resonators with different free spectral ranges (FSRs) are typically used together to enable, via the Vernier effect, a single, widely tunable mode. However, in some embodiments, a Vernier ring approach may use two TOPS elements, two controllers, and a calibration and control procedure that is more complicated than that of a DBR. Accordingly, the single ring embodiments of the disclosure avoid these challenges and expensive duplication of components. In various embodiments, the external cavity lasers disclosed herein generate a single mode laser output.

Refer now to the exemplary embodiment of Figure 2C. Many embodiments of the current disclosure include a DBR ring comprising a circular DBR combined with a ring resonator and a circular TOPS element. Figure 2C shows a reflection spectrum 210 and a transmission spectrum 215 of a DBR ring of radius 40.7 µm and circumference 256.0 µm. Figure 2C also shows a reflection spectrum 205c of a 256 µm long linear, conventional DBR. The reflection spectrum 205c of the linear, conventional DBR provides a reflectivity of only -14.3 dB. However, in various embodiments, when a circular DBR with circumference about 256.0 µm is combined with a high-Q ring resonator, a peak of a reflectivity spectrum 210 reaches nearly 100% or approximately 0 dB. Equivalently, a transmission spectrum 215 of the DBR ring features a sharp notch. In addition, in most embodiments, a wavelength comb in a reflection spectrum of a ring resonator is suppressed by nodes in a reflection spectrum of the DBR. In various embodiments, the DBR ring supports a laser cavity that lases at a single resonant mode. In some embodiments, the supporting lasing at a single resonant mode may be achieved by using the various parameters described herein.

In many embodiments, the DBR ring laser configuration enables very low power consumption and simple control for wavelength tuning. Because the DBR and the ring resonator are combined or coupled in one component and their resonant wavelengths are naturally synchronized, only one compact TOPS, with its length equal to DBR ring circumference, is typically used to shift a resonant wavelength. This automatically synchronized phase control of DBR and ring simplifies the physical structure and the control loop, especially for an uncooled laser.

In various embodiments, a given laser or laser-based system may include an optical component in optical communication with the laser output. The optical component may be selected from various components such as an optical modulator, an optical sensor, a LiDAR-based component, a system-on-chip, a local oscillator, an optical waveguide and combinations thereof. In various embodiments, operation of the laser and transmitting light therefrom is performed while the external laser cavity is in an uncooled state. In some embodiments, the external laser cavity is configured to operate in an uncooled state or cooled state.

Having thus described several aspects and embodiments of the technology of this application, it is to be appreciated that various alterations, modifications, and improvements will readily occur to those of ordinary skill in the art. Such alterations, modifications, and improvements are intended to be within the spirit and scope of the technology described in the application. It is, therefore, to be understood that the foregoing embodiments are presented by way of example only and that, within the scope of the appended claims and equivalents thereto, inventive embodiments may be practiced otherwise than as specifically described. In addition, any combination of two or more features, systems, articles, materials, and/or methods described herein, if such features, systems, articles, materials, and/or methods are not mutually inconsistent, is included within the scope of the present disclosure.

Also, as described, some aspects may be embodied as one or more methods. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

The phrase "and/or," as used herein in the specification and in the claims, should be understood to mean "either or both" of the elements so conjoined, i.e., elements that are conjunctively present in some cases and disjunctively present in other cases.

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified.

The terms "substantially" and "approximately" and "about" may be used to mean within ±20% of a target value in some embodiments, within ±10% of a target value in some embodiments, within ±5% of a target value in some embodiments, and yet within ±2% of a target value in some embodiments. The terms "substantially" and "approximately" and "about" may include the target value.

In the claims, as well as in the specification above, all transitional phrases such as "comprising," "including," "carrying," "having," "containing," "involving," "holding," "composed of," and the like are to be understood to be open-ended, i.e., to mean including but not limited to. The transitional phrases "consisting of" and "consisting essentially of" shall be closed or semi-closed transitional phrases, respectively.

Where a range or list of values is provided, each intervening value between the upper and lower limits of that range or list of values is individually contemplated and is encompassed within the disclosure as if each value were specifically enumerated herein. In addition, smaller ranges between and including the upper and lower limits of a given range are contemplated and encompassed within the disclosure. The listing of exemplary values or ranges is not a disclaimer of other values or ranges between and including the upper and lower limits of a given range.

Embodiments disclosed herein may be embodied as a system, method or computer program product. Accordingly, embodiments may take the form of an entirely hardware embodiment, an entirely software embodiment (including firmware, resident software, microcode, etc.) or an embodiment combining software and hardware aspects that may all generally be referred to herein as a "circuit," "module," or "system." Furthermore, embodiments may take the form of a computer program product embodied in one or more computer readable medium(s) having computer readable program code embodied thereon.

## Claims

1. A laser comprising:
a laser cavity;
an optical gain chip comprising a gain material, the gain material having a gain region, the optical gain chip comprising:
a first waveguide, wherein the first waveguide defines a first section of the laser cavity;
an external laser cavity comprising:
a second waveguide, wherein the second waveguide is optically coupled to the first waveguide, the second waveguide defines a second section of the laser cavity; and
a distributed Bragg reflector (DBR) ring optically coupled to the second waveguide, the DBR ring comprising:
a loop waveguide optically coupled to the second waveguide; and
one or more DBR disposed along one or more sections of the loop waveguide, wherein the laser cavity comprises the first section of the laser cavity and the external laser cavity; and
a photonic integrated circuit (PIC), the PIC comprising the second waveguide and the DBR ring.

2. The laser of claim 1, wherein any one or more of:
A) the external laser cavity is configured to operate in an uncooled state or cooled state;
B) the one or more sections of the loop waveguide is a circumference or one or more arcs of the loop waveguide;
C) the DBR ring is a wavelength-selective filter configured to select a lasing wavelength of the laser cavity, wherein a diameter of the DBR ring ranges from about 2.0 µm to about 2.0 mm;
D) the gain chip comprises one or more group III-V semiconductor materials, wherein the gain region comprises one or more quantum well or quantum dot structures;
E) the optical gain chip emits light having a gain chip wavelength range, wherein the gain chip wavelength range spans a width of about 20 nm to about 200 nm, wherein the DBR ring circulates coherent light having a central wavelength with a wavelength spread of ± about 8 nm..

3. The laser of any preceding claim, wherein the photonic integrated circuit (PIC) comprises the external laser cavity, wherein a length of the second waveguide ranges from about 0.1 µm to about 2 cm.

4. The laser of claim 3, wherein the optical gain chip further comprises a first facet and a second facet, wherein the first facet is coated in a first coating, wherein the first waveguide has a first end that coincides with the first facet and second end that coincides with the second facet.

5. The laser of claim 4, wherein the first coating is selected from a group consisting of an anti-reflective coating, a partially reflective coating, and a reflective coating.

6. The laser of claim 5, wherein the second facet is coated in a second coating, wherein the second coating is selected from a group consisting of an anti-reflective coating, a partially reflective coating, and a reflective coating.

7. The laser of claim 5 or 6, further comprising a laser output, wherein the laser cavity in optical communication with the laser output, wherein the laser output is disposed in the PIC or wherein the laser output receives laser light from the second end.

8. The laser of claim 7, wherein the laser output outputs a single mode of laser light.

9. The laser of claim 4 further comprising: a laser output in optical communication with the DBR ring, wherein the laser output transmits greater than about 50% of optical power of an optical signal selected by the DBR, wherein the PIC comprises the laser output.

10. The laser of claim 9 further comprising: an optical component in optical communication with the laser output, wherein the optical component is selected from the group consisting of an optical modulator, an optical sensor, a LiDAR-based component, a system-on-chip, a local oscillator, a transmitter, a receiver, and an optical waveguide.

11. The laser of any preceding claim further comprising: a thermo-optical phase shifter, wherein the thermo-optical phase shifter is in thermal communication with at least a portion of the second waveguide.

12. A method comprising:
transmitting a laser beam back and forth between a gain chip and an external laser cavity, wherein the gain chip provides optical gain, wherein a wavelength of the laser beam is tunable within a range;
selecting, using a DBR ring, a center wavelength from the range of wavelengths;
transmitting the laser beam having a center wavelength from the DBR to a first waveguide;
selecting, using one or more parameters of the DBR ring, between a transmission direction and a reflection direction, wherein the transmission direction is orientable towards a laser output; and
transmitting the laser beam having a center wavelength from the laser output.

13. The method of claim 12, wherein the one or more parameters of the DBR ring are one or both of a DBR grating coupling constant and a DBR ring coupling efficiency, wherein the DBR ring coupling efficiency ranges from about 5.0% to 95%, wherein the DBR grating coupling constant ranges from about 0.1 to about 100.

14. The method of claim 12 or 13, wherein one or both of:
A) transmitting the laser beam is performed while the external laser cavity is in an uncooled state;
B) the laser output transmits greater than about 50% of optical power at an optical wavelength selected by the DBR in the transmission direction.

15. The method of any of claims 12 to 14 further comprising tuning a TOPS in thermal communication with the DBR ring such that a wavelength tuning range relative to the center wavelength is ± about 8 nm.
